# DEMANDE DE BREVET EUROPEEN

(11) **EP 4 098 608 A1**
(43) Date de publication de la demande: **07.12.2022**
(21) Numéro de dépôt: 22175726.3
(22) Date de dépôt: 27.05.2022
(51) Int. Cl.: B81C 99/00, B25J 15/06, B25J 7/00

(54) **MICROSYSTÈME ÉLECTROMÉCANIQUE**

(30) Priorité: 31.05.2021 FR 2105642
(71) Demandeur: Commissariat à l'énergie atomique et aux énergies alternatives, 75015 Paris (FR)
(72) Inventeur: MOLLARD, Laurent, 38054 GRENOBLE Cedex 09 (FR); NICOLAS, Stéphane, 38054 GRENOBLE Cedex 09 (FR); SAINT-PATRICE, Damien, 38054 GRENOBLE Cedex 09 (FR)
(74) Mandataire: Hautier IP

(57) **Abrégé**

L'invention concerne un microsystème électromécanique 1 comprenant un transducteur électromécanique 11, une membrane déformable 12, une première cavité 13 contenant hermétiquement un milieu déformable 14 conservant un volume constant sous l'action d'un changement de pression externe et une deuxième cavité. La membrane déformable forme une paroi de la cavité et présente au moins une zone libre 121 de se déformer de façon élastique. La zone libre forme également une paroi de la deuxième cavité. Le transducteur électromécanique est configuré de sorte que son mouvement soit fonction dudit changement de pression externe, et inversement. Un changement de pression externe dans la première cavité 13 induit une variation du volume de la deuxième cavité 20, ou inversement. Ainsi, le microsystème électromécanique proposé permet la préhension d'un objet obstruant l'ouverture de la deuxième cavité ou constitue un microbaromètre propre à convertir au moins un changement de pression ambiante en un signal électrique.

## Description

### DOMAINE TECHNIQUE

La présente invention concerne le domaine des microsystèmes électromécaniques. Elle trouve pour application des dispositifs de préhension qui permettent la capture ou l'expulsion d'objets de petites tailles et/ou de petits poids. L'invention trouve également pour application le domaine de la détection par contact ou le domaine de la détection de variation de pression ambiante. Elle pourra ainsi être mise en œuvre pour réaliser des capteurs.

### ÉTAT DE LA TECHNIQUE

Dans des applications variées, on peut avoir besoin de capturer ou expulser des objets microscopiques, voire nanoscopiques, et/ou avoir besoin de capter la présence de tels objets. Il existe des microsystèmes qui permettent cela.

Lorsque ces microsystèmes sont des actionneurs ou des dispositifs de préhension, leurs performances sont évaluées notamment sur les paramètres suivants: l'amplitude du déplacement, la force déployée, la précision du déplacement généré ou encore la précision de la capture ou de l'expulsion d'un objet. Lorsque ces microsystèmes sont des capteurs, leurs performances sont évaluées notamment sur leur capacité à capter une présence, voire un mouvement.

Par ailleurs, que les microsystèmes soient des actionneurs, des dispositifs de préhension ou des capteurs, on recherche à ce qu'ils offrent de bonnes performances en termes d'encombrement et de consommation énergétique.

Toutes les solutions connues présentent des performances faibles pour l'un au moins de ces paramètres. Généralement, les microsystèmes existants présentent des performances trop peu satisfaisantes pour une combinaison de ces paramètres.

Un objet de la présente invention est de proposer un microsystème électromécanique qui présente des performances améliorées par rapport aux solutions existantes, au moins pour l'un des paramètres mentionnés ci-dessus, ou qui présente un meilleur compromis concernant au moins deux des paramètres susmentionnés.

Un autre objet de la présente invention est de proposer un microsystème qui permette la préhension d'un objet de petites tailles et/ou de petits poids de manière fiable et robuste.

Un autre objet de la présente invention est de proposer un microsystème qui permette de capter une variation de pression ambiante.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, on prévoit un microsystème électromécanique comprenant :
- au moins un transducteur électromécanique comprenant une partie mobile entre une position d'équilibre, hors sollicitation, et une position hors équilibre, sous sollicitation,
- au moins une membrane déformable,
- une première cavité déformable, délimitée par des parois, au moins une partie de la membrane déformable formant au moins une partie d'une première paroi prise parmi lesdites parois de la première cavité, la première cavité étant configurée pour contenir hermétiquement un milieu déformable propre à conserver un volume sensiblement constant sous l'action d'un changement de pression externe exercée sur le milieu déformable à travers l'une des parois de la première cavité,
- au moins une deuxième cavité déformable, présentant un volume variable délimité par des parois et une ouverture.

La partie mobile du transducteur électromécanique est configurée de sorte que son mouvement soit fonction dudit changement de pression externe, ou inversement que son mouvement induise un changement de pression externe dans la première cavité.

Ladite au moins une partie de la membrane déformable présente au moins une zone libre de se déformer, de préférence de façon élastique, en fonction dudit changement de pression externe.

Au moins une partie d'une première paroi prise parmi lesdites parois de la deuxième cavité est formée d'au moins une partie de ladite au moins une zone libre de la membrane, de sorte qu'un changement de pression externe dans la première cavité induise une variation du volume de la deuxième cavité, ou inversement qu'une variation du volume de la deuxième cavité induise un changement de pression externe dans la première cavité.

Ainsi, le microsystème électromécanique proposé permet la préhension d'un objet obstruant l'ouverture de la deuxième cavité ou constitue un microbaromètre propre à convertir au moins un changement de pression ambiante en un signal électrique.

Selon une particularité, l'ouverture de la deuxième cavité est destinée à être alternativement obstruée et dégagée par un objet.

Le microsystème permet donc la préhension d'un objet. En effet, la variation de volume de la deuxième cavité induit un différentiel de pression dans la deuxième cavité lorsque celle-ci est obstruée et permet ainsi le maintien ou l'expulsion de l'objet obstruant la cavité. Plus particulièrement, une augmentation du volume de la deuxième cavité obstruée par l'objet induit une diminution de pression dans la deuxième cavité permettant d'aspirer celui-ci et ainsi de le maintenir. Au contraire, une diminution du volume de la deuxième cavité obstruée par l'objet induit une augmentation de pression dans la deuxième cavité permettant de relâcher, voire d'expulser, l'objet.

Un autre aspect de l'invention concerne un ensemble comprenant un microsystème électromécanique tel qu'introduit ci-dessus et au moins un objet destiné à obstruer l'ouverture. Il peut s'agir d'un objet à saisir ou à expulser par le microsystème électromécanique. De préférence la paroi latérale définie une extrémité distale et l'ouverture est formée au moins en partie par l'extrémité distale de la paroi latérale.

Selon un exemple, l'ensemble de l'extrémité distale de la paroi latérale est conformée de sorte à ce que, lorsque l'objet obstrue l'ouverture, une déformation de la membrane déformable tendant à augmenter le volume de la deuxième cavité créer une baisse de pression dans la deuxième cavité.

Selon un exemple l'extrémité distale de la paroi latérale est conformée de sorte à ce que la coopération de l'objet et de l'extrémité distale assure une étanchéité à l'air de la deuxième cavité suffisante pour créer une baisse de pression lorsque le volume de la deuxième cavité augmente sous l'effet d'une déformation de la déformable membrane.

Un autre aspect de l'invention concerne un procédé de fabrication d'un microsystème électromécanique tel qu'introduit ci-dessus, comprenant, voire étant limité à, des étapes de dépôt et de gravure ordinaires en microélectronique. Le microsystème électromécanique peut en effet être fabriqué par des moyens ordinaires de la microélectronique, ce qui confère à son fabricant tous les avantages découlant de l'utilisation de ces moyens, dont une grande latitude en termes de dimensionnement, d'énergie d'adhésion entre les différents dépôts, d'épaisseur des différents dépôts, d'étendue de gravure, etc.

Selon un exemple le procédé de fabrication du microsystème électromécanique comprend les étapes suivantes :
- une étape de formation, sur un substrat, d'une portion au moins dudit au moins un transducteur électromécanique, puis
- une étape de dépôt de la membrane déformable, puis
- une étape de formation d'au moins une première cavité ouverte sur la membrane déformable, puis
- une étape de remplissage avec le milieu déformable et de fermeture de la première cavité, et
- une étape de gravure du substrat pour former une deuxième cavité ouverte et une face avant (FAV) du microsystème électromécanique comprenant la deuxième cavité.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1A est un schéma de principe d'une vue en coupe ou d'une coupe d'un microsystème électromécanique selon un premier mode de réalisation de l'invention. Sur la figure 1A, le microsystème électromécanique est illustré dans une configuration dans laquelle la membrane n'est pas déformée.
La figure 1B représente une vue de haut du microsystème électromécanique selon le premier mode de réalisation de l'invention illustré sur la figure 1A.
La figure 1C représente une vue de haut d'une variante du mode de réalisation de l'invention illustré sur la figure 1B.
La figure 2A est un schéma de principe d'une vue en coupe ou d'une coupe d'un microsystème électromécanique selon un deuxième mode de réalisation de l'invention. Sur la figure 2A, le microsystème électromécanique est illustré dans une configuration dans laquelle la membrane n'est pas déformée.
La figure 2B représente une vue de haut du microsystème électromécanique selon le deuxième mode de réalisation de l'invention illustré sur la figure 2A.
La figure 3A est un schéma de principe d'une vue en coupe d'un microsystème électromécanique selon le premier mode de réalisation de l'invention et d'un objet à saisir. Sur la figure 3A, le microsystème électromécanique est illustré dans une configuration dans laquelle la membrane n'est pas déformée.
La figure 3B est un schéma de principe d'une vue en coupe du microsystème illustré en figure 3A, dans une première configuration de déformation de la membrane.
La figure 3C est un schéma de principe d'une vue en coupe du microsystème illustré en figure 3A, dans une deuxième configuration de déformation de la membrane.
Les figures 4A et 4B illustrent un mode d'utilisation du microsystème selon le premier mode de réalisation de l'invention ; la figure 4A illustre l'état du microsystème lorsqu'il est reporté sur l'objet à saisir et la figure 4B illustre l'état du microsystème lorsqu'il a saisi l'objet.
La figure 5 est un schéma, plus détaillé que celui de la figure 1A et représentant un microsystème électromécanique structurellement proche de celui illustré sur la figure 1A.
Les figures 6 à 12 représentent schématiquement des étapes d'un exemple de procédé de réalisation du microsystème électromécanique illustré en figure 5.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches, parois et organes illustrés ne sont pas nécessairement représentatives de la réalité.

### DESCRIPTION DÉTAILLÉE

Selon un exemple, la membrane présentant une face interne configurée pour être au contact du milieu déformable et une face externe, la face interne de la membrane forme au moins une partie de la première paroi de la première cavité et la face externe de la membrane forme au moins une partie de la première paroi de la deuxième cavité. Ainsi, par construction, la paroi déformable de la deuxième cavité forme au moins une partie du fond de la deuxième cavité.

Selon un exemple, une zone sur laquelle s'étend la première paroi de la deuxième cavité est exempte de toute partie mobile d'un transducteur électromécanique. On bénéficie ainsi au mieux de l'effet d'amplification hydraulique sur la variation de volume de la deuxième cavité.

Selon un exemple, le microsystème comprend en outre une couche souple, par exemple à base d'un matériau choisi parmi le silicone et le parylène, configurée pour être intercalée entre au moins l'une des parois de la deuxième cavité et une partie de l'objet obstruant la deuxième cavité.

Selon un exemple, la deuxième cavité comprend, parmi ces parois, une paroi latérale s'étendant depuis un pourtour de sa première paroi à l'opposé de la première cavité. La paroi latérale est de préférence pleine et indéformable relativement à la capacité de déformation de la zone libre de la membrane déformable. L'on s'assure ainsi de l'herméticité de la deuxième cavité lorsqu'elle est obstruée par l'objet. On s'assure également de préserver l'intégrité du microsystème et de l'objet, notamment lorsque l'un est reporté sur l'autre. L'on s'assure en outre de conférer à la deuxième cavité un volume suffisant et paramétrable en fonction de l'étendue de sa paroi latérale, de sorte que toute variation de volume souhaitée en fonction de l'application visée soit atteignable. Plus particulièrement, la paroi latérale permet de par sa forme et/ou ses dimensions de définir un volume de la deuxième cavité plus grand qu'en son absence. Ainsi, des déformations d'amplitude plus importantes de la membrane déformable au niveau de sa zone libre sont rendues possibles, avant que la membrane déformée ne dépasse de l'ouverture de la deuxième cavité, notamment quand le transducteur est configuré pour déformer la membrane dans un sens opposé au centre de la première cavité.

En complément à l'exemple précédent, l'ouverture de la deuxième cavité peut être formée par l'extrémité distale de la paroi latérale. L'extrémité distale de la paroi latérale de la deuxième cavité est opposée à la première cavité, son extrémité proximale pouvant s'étendre depuis une paroi de la première cavité. C'est sur cette extrémité distale de la paroi latérale que la couche souple peut être déposée.

Selon un exemple, la première paroi de la deuxième cavité est formée d'une partie seulement de ladite au moins une zone libre de la membrane, la deuxième cavité comprenant une paroi latérale s'étendant depuis ladite au moins une zone libre de la membrane.

Selon un exemple, le microsystème comprend une pluralité de deuxièmes cavités séparées les unes des autres d'une distance non nulle. Lorsque plusieurs deuxièmes cavités s'étendent depuis une même paroi de la première cavité, il est permis de répartir les forces s'exerçant sur un objet obstruant les deuxièmes cavités en différents endroits de l'objet ou sur différentes surfaces de l'objet. En outre, le microsystème électromécanique est ainsi rendu résilient à un éventuel dysfonctionnement d'une deuxième cavité, voire de plusieurs deuxièmes cavités. De plus, les conditions de placement de l'objet relativement au microsystème afin que l'objet puisse être maintenu peuvent être relâchées. Par ailleurs, que plusieurs deuxièmes cavités s'étendent depuis une même paroi de la première cavité ou depuis des parois différentes entre elles de la première cavité, le microsystème peut ainsi permettre de maintenir et relâcher une pluralité d'objets, chaque objet obstruant au moins une deuxième cavité de la pluralité.

Selon un exemple, la partie mobile d'au moins un transducteur électromécanique est configurée de sorte que sa sollicitation induise son mouvement vers le centre de la première cavité, une déformation de la zone libre de la membrane déformable à l'opposé du centre de la première cavité et par voie une diminution du volume de la deuxième cavité et de sorte qu'une absence subséquente de sollicitation induise son mouvement à l'opposé du centre de la cavité, une déformation de la zone libre de la membrane déformable vers le centre de la première cavité et par voie une augmentation du volume de la deuxième cavité. Il est ainsi possible de maintenir un objet obstruant la deuxième cavité sans avoir à solliciter le transducteur électromécanique pendant le maintien de l'objet. L'objet peut en outre être relâché, voire expulsé, en sollicitant à nouveau le transducteur électromécanique.

Selon un exemple, ledit au moins un transducteur électromécanique est configuré de sorte à induire sélectivement une diminution et une augmentation du volume de la deuxième cavité.

Selon un exemple, ledit au moins un transducteur électromécanique peut être solidaire de la membrane déformable sur une zone située hors de la zone libre, et plus particulièrement sur une zone distante de la zone libre, de sorte que tout mouvement de la partie mobile du transducteur induise un étirement ou une relaxation de la membrane déformable.

Selon un exemple, ledit au moins un transducteur électromécanique est configuré pour exercer sur le milieu déformable lorsqu'il est sollicité un changement de pression externe déterminé et dans lequel la forme et/ou les dimensions de ladite au moins une zone libre de la membrane déformable sont configurées pour induire, en fonction dudit changement de pression externe déterminé, une variation de volume de la deuxième cavité propre à générer une force d'aspiration d'un objet obstruant l'ouverture supérieure au poids de l'objet. Le microsystème selon cette caractéristique trouve particulièrement à s'appliquer dans les machines dites de type « pick-and-place ».

Lorsque le microsystème électromécanique comprend la partie mobile d'un unique transducteur électromécanique et une unique zone libre, ladite au moins une partie d'une des parois de la deuxième cavité est formée au moins en partie de l'unique zone libre à l'exclusion de la partie mobile de l'unique transducteur électromécanique. Toutefois, dans l'absolu, au moins une partie d'au moins une des parois de la deuxième cavité peut être formée au moins en partie par au moins la partie mobile d'au moins un transducteur électromécanique.

Selon un exemple, la zone libre forme un disque, une ellipse ou un polygone.

Selon un exemple, le microsystème électromécanique comprend une pluralité de transducteurs électromécaniques.

Selon un mode de réalisation, les transducteurs électromécaniques sont séparés les uns des autres. Leurs parties mobiles ne sont pas en contact.

Selon un exemple, un transducteur électromécanique entoure, au moins partiellement, voire entièrement, un ou plusieurs autres actionneurs électromécaniques, en particulier leur partie mobile. En outre, ils peuvent être actionnés indépendamment les uns des autres.

De préférence, chaque transducteur électromécanique présente une partie mobile configurée de sorte que son mouvement soit fonction dudit changement de pression externe, ou inversement que son mouvement induise un changement de pression externe exercée sur le milieu déformable à travers l'une des parois de la cavité.

Ainsi, le microsystème électromécanique comporte plusieurs transducteurs électromécaniques pour une première cavité.

Selon un exemple, au moins certains des transducteurs électromécaniques de ladite pluralité sont configurés pour que, sous sollicitation, leurs parties mobiles, induisent des déformations de la zone libre de la membrane.

Ainsi, au moins certains de ces transducteurs électromécaniques permettent de déformer la zone libre de la membrane avec une amplitude déterminée. La déformation totale de la zone libre résulte du cumul du déplacement des parties mobiles de ces transducteurs électromécaniques. Le microsystème électromécanique présente ainsi un fonctionnement pas à pas. Cela permet de contrôler pas à pas, et/ou avec une grande précision, la dépression ou la surpression créée dans la deuxième cavité. Par ailleurs, cela peut permettre d'augmenter l'amplitude de la variation de volume de la deuxième cavité et/ou de limiter la tension de commande des transducteurs électromécaniques.

Les transducteurs électromécaniques peuvent être sollicités simultanément ou successivement. L'amplitude de déformation de la zone libre induite par chaque transducteur électromécanique peut être identique ou différente.

Selon un exemple, au moins certains des transducteurs électromécaniques de ladite pluralité sont configurés pour que, sous sollicitation, leurs parties mobiles, induisent des déformations de la zone libre de la membrane dans deux sens opposés.

Ainsi, au moins deux de ces transducteurs électromécaniques permettent de déformer la zone libre selon deux directions opposées. Ces deux transducteurs électromécaniques sont donc antagonistes. Ainsi, au moins l'un de ces transducteurs électromécaniques permet de créer une dépression dans la deuxième cavité et au moins un autre de ces transducteurs électromécaniques permet de créer une surpression dans la deuxième cavité.

Ces deux transducteurs électromécaniques antagonistes peuvent être séparés l'un de l'autre d'une distance non nulle. Alternativement, l'un de ces transducteurs électromécaniques peut entourer, de préférence entièrement, l'autre transducteur électromécanique. Selon un autre mode de réalisation, un même transducteur permet d'effectuer ces deux mouvements alternatifs. On pourra pour cela utiliser un transducteur en AIN par exemple.

Selon un exemple, le microsystème électromécanique comprend plusieurs zones libres, séparées les unes des autres d'une distance non nulle.

Ces zones libres peuvent être formées par une même membrane. Alternativement, ces zones libres peuvent être formées par des membranes distinctes.

Selon un exemple, la zone libre est libre de se déformer, de préférence de façon élastique, en fonction dudit changement de pression externe.

Le microsystème électromécanique tel qu'introduit ci-dessus est de préférence exempt d'élément optique, telle qu'une lentille, notamment à focale variable.

Selon un exemple, au moins une partie du transducteur électromécanique forme une partie de la paroi de la cavité qui est en partie formée par la membrane déformable. Le microsystème électromécanique selon cette caractéristique présente une structure non-traversante, laissant libres les autres parois de la cavité de sorte à pouvoir y réaliser d'autres fonctions ou de sorte à leur permettre de rester inertes, pour une capacité d'intégration accrue notamment dans une machine de type « pick-and-place ».

Selon un exemple, le transducteur électromécanique s'étend, directement sur la membrane déformable, c'est-à-dire que le transducteur électromécanique est directement au contact de la membrane déformable. Alternativement le transducteur électromécanique s'étend indirectement sur la membrane déformable c'est-à-dire qu'au moins un élément ou une couche intermédiaire est disposé entre le transducteur électromécanique et la membrane déformable. De préférence le transducteur électromécanique s'étend autour de la zone libre de la membrane déformable.

Notamment, lorsque le microsystème comprend plusieurs transducteurs électromécaniques, l'un des transducteurs peut prendre une forme annulaire dont le centre circulaire défini l'étendue de la zone libre de la membrane déformable.

La partie mobile du transducteur électromécanique peut présenter une surface au moins deux fois supérieure, voire au moins 5 fois supérieure, et de préférence au moins dix fois supérieure à une surface de la zone libre de la membrane déformable, voire à la surface des zones libres de la membrane déformable. Plus la surface du transducteur est importante par rapport à la surface de la zone libre, plus l'amplitude de déformation de la zone libre de la membrane sera importante.

La membrane déformable est de préférence configurée de sorte que sa zone libre soit capable de se déformer avec une amplitude d'au moins 50 µm, voire d'au moins 100µm, voire d'au moins 1000µm selon une direction perpendiculaire au plan dans lequel s'étend principalement la paroi de la première cavité formée par la membrane déformable. Sans se déchirer et/ou sans usure significative, le microsystème électromécanique offre ainsi la capacité à satisfaire de nombreuses et diverses applications nécessitant une grande variation de pression, cette dernière étant définie le cas échéant par domaine technique concerné.

Selon un exemple, au moins une partie du transducteur électromécanique forme une partie de ladite première paroi de la cavité.

Le microsystème électromécanique peut comprendre en outre une butée dite basse supportée par la paroi de la première cavité opposée à la zone libre de la membrane déformable, ladite butée basse s'étendant dans la première cavité vers la zone libre. Elle présente une forme et des dimensions configurées pour limiter la déformation de la zone libre de la membrane déformable de sorte à protéger la membrane déformable, et plus particulièrement sa zone libre, notamment d'un éventuel arrachement, lors d'un report de l'objet et du microsystème l'un sur l'autre. Par ailleurs, la butée dite basse est conformée pour limiter la surface de contact entre la membrane et la paroi de la première cavité opposée à la zone libre de la membrane déformable. De manière alternative ou cumulée, la butée basse est conformée de sorte à limiter la surface de contact entre la membrane et la paroi de la première cavité opposée à la zone libre de la membrane déformable. Cela permet d'éviter que la membrane n'adhère à cette paroi.

Le transducteur électromécanique peut être un transducteur piézoélectrique, de préférence comprenant un matériau piézoélectrique à base de PZT.

Le milieu déformable contenu hermétiquement dans la première cavité peut comprendre au moins l'un parmi un fluide et un liquide, le milieu déformable présentant de préférence une viscosité de l'ordre de 100 cSt à température et pression ambiantes.

Selon un exemple de réalisation non limitatif, le milieu déformable présente une compressibilité comprise entre 10⁻⁹ et 10⁻¹⁰ Pa⁻¹ à 20°C, par exemple de l'ordre de 10⁻¹⁰ Pa⁻¹ à 20°C, sans que ces valeurs soient limitatives.

Le microsystème électromécanique tel qu'introduit ci-dessus peut comprendre en outre une pluralité de membranes déformables et/ou une pluralité de zones libres par membrane déformable. Par exemple, au moins une zone libre est distante, de préférence non jointive, d'une paroi de la deuxième cavité.

Le transducteur électromécanique peut être alimenté par des tensions électriques produites avec des circuits électroniques avoisinants.

Un « microsystème » est un système dont les dimensions externes sont inférieures à 1 centimètre (10⁻² mètres) et de préférence à 1 millimètre (10⁻³ mètres).

Un transducteur électromécanique joue un rôle d'interface entre les domaines mécanique et électrique. Un transducteur électromécanique peut comprendre une partie mobile entre une position d'équilibre, hors sollicitation, et une position hors équilibre, sous sollicitation. Lorsque le transducteur est piézoélectrique, la sollicitation est de nature électrique.

Lorsqu'il est fait mention du centre de la cavité, ce centre est défini géométriquement en considérant le centre d'une cavité présentant une zone libre non déformée de la membrane déformable.

On entend par « inférieur » et « supérieur », « inférieur ou égal » et supérieur ou égal », respectivement. L'égalité est exclue par l'usage des termes « strictement inférieur » et « strictement supérieur ».

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

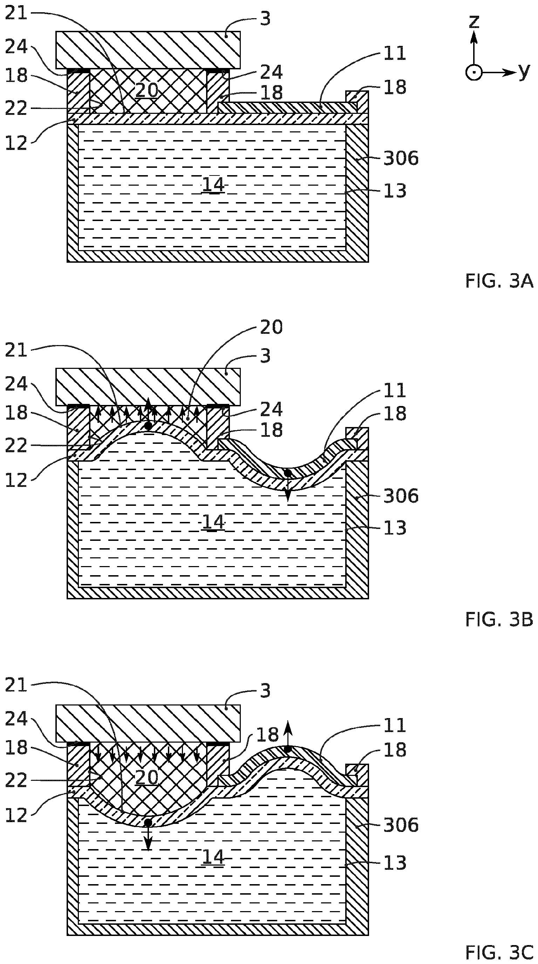

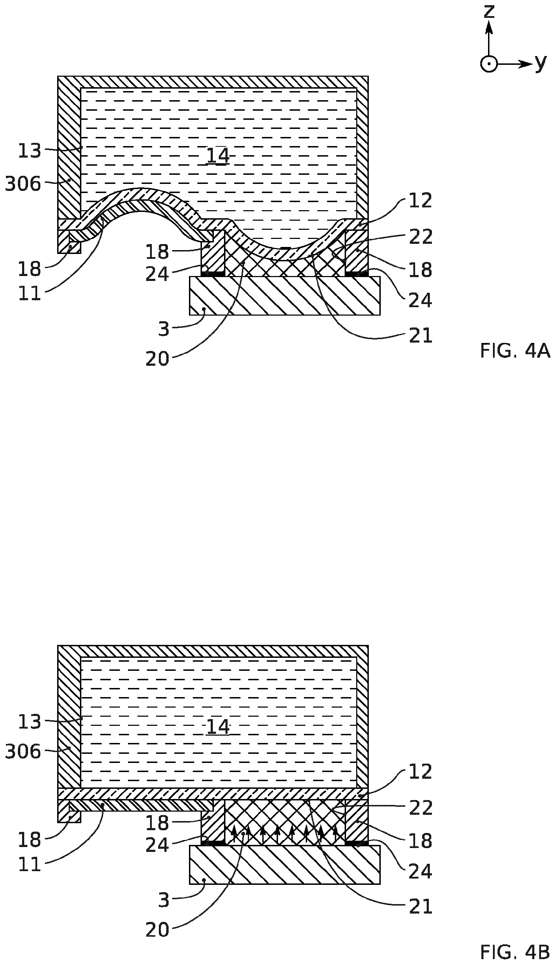

Comme cela sera décrit plus en détail par la suite le microsystème électromécanique 1 selon l'invention peut, selon sa configuration et son utilisation, assurer plusieurs fonctions:
- En tant que dispositif de préhension, il peut permettre de saisir ou expulser un objet 3 comme illustré sur les figures 3A à 3C et 4A à 4B.
- En tant que capteur, il peut notamment permettre de capter une variation de pression ambiante.

Les caractéristiques permettant d'assurer ces différentes fonctions vont maintenant être décrites en détails en référence aux figures.

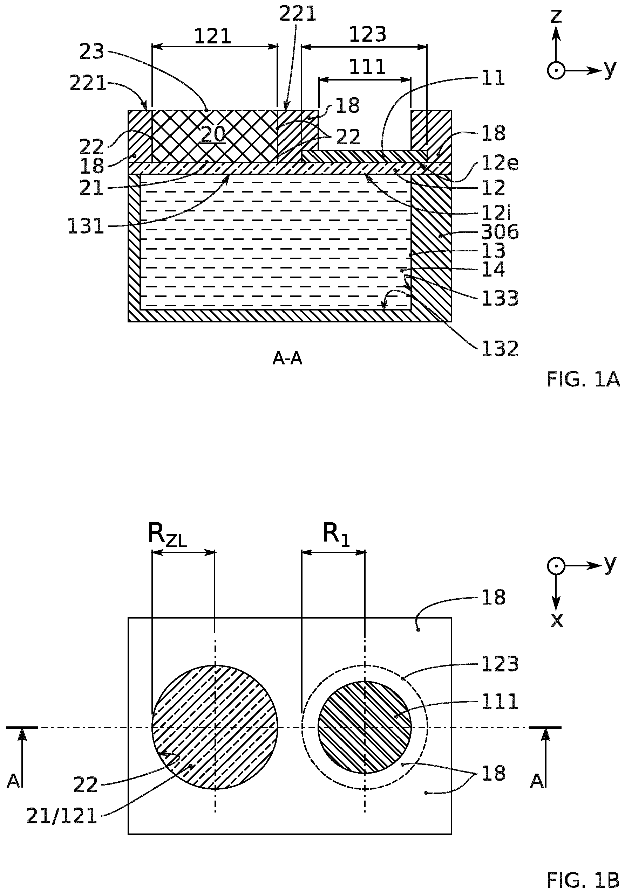

La figure 1A est un schéma de principe d'un premier mode de réalisation du microsystème électromécanique 1 selon l'invention. Les figures 3A à 3C illustrent le microsystème électromécanique de la figure 1A, en cours d'utilisation selon un premier mode de fonctionnement. Les figures 4A et 4B illustrent le microsystème électromécanique de la figure 1A, en cours d'utilisation selon un deuxième mode de fonctionnement.

En figure 1A sont illustrés un transducteur électromécanique 11, une membrane déformable 12, une première cavité 13 configurée pour contenir hermétiquement un milieu déformable 14 et une deuxième cavité 20 présentant un volume délimité par des parois 21, 22 et une ouverture 23. La membrane déformable 12 présente une zone libre 121 de se déformer sous l'action d'un changement de pression externe exercée sur le milieu déformable 14. La déformation de la zone libre 121 de la membrane déformable 12 permet de faire varier le volume de la deuxième cavité 20.

Avant de décrire plus en détail les différents modes de réalisation de l'invention illustrés sur les figures, notons que chacune de ces illustrations représente schématiquement un mode de réalisation du microsystème électromécanique qui présente une structure non traversante. Plus particulièrement, dans les différents modes illustrés, chaque transducteur électromécanique 11, 11a, 11b et la membrane déformable 12 se situe en face avant FAV du microsystème électromécanique 1. Ce type de structure est particulièrement avantageux dans la mesure où la face arrière FAR du microsystème électromécanique 1 peut participer uniquement de façon passive, et en particulier sans se déformer, à la fonction du microsystème électromécanique 1.

Plus particulièrement, la face arrière FAR d'un microsystème électromécanique 1 à structure non traversante selon l'invention peut notamment constituer une face par laquelle le microsystème électromécanique 1 peut être aisément monté sur un support et/ou peut constituer une face par laquelle le microsystème électromécanique peut aisément être davantage fonctionnalisé. Lorsque le microsystème électromécanique 1 est monté sur un support, ce support peut par exemple être un support mobile dans les trois dimensions de l'espace ou connu pour avoir une mobilité dite à 2,5 dimensions. Un tel support mobile peut faire partie d'une machine dite « pick-and-place ».

Toutefois, l'invention n'est pas limitée à des microsystèmes électromécaniques à structure non traversante. L'invention concerne également des microsystèmes électromécaniques 1 dits à structure traversante dans lesquels au moins un transducteur électromécanique 11, 11a, 11b et la membrane déformable 12 sont agencés sur des parois distinctes entre elles de la cavité 13, que ces parois soient adjacentes ou opposées entre elles.

### Transducteur électromécanique 11, 11a et 11b

Chaque transducteur électromécanique 11, 11a, 11b comprend au moins une partie mobile 111, 111a, 111b. Cette dernière est configurée pour se mouvoir ou être mue entre au moins deux positions. Une première de ces positions est une position d'équilibre atteinte et conservée lorsque le transducteur électromécanique 11, 11a, 11b n'est pas sollicité, que ce soit par exemple par une tension électrique ou par une force la contraignant hors de sa position d'équilibre. Une deuxième position de la partie mobile 111, 111a, 111b du transducteur électromécanique 11, 11a, 11b est atteinte lorsque le transducteur électromécanique 11, 11a, 11b est sollicité, que ce soit par exemple par une tension électrique ou par une force la contraignant hors de sa position d'équilibre. Le transducteur électromécanique 11, 11a, 11b peut être maintenu dans l'une ou l'autre des première et deuxième positions décrites ci-dessus, et présenter ainsi un comportement binaire, ou peut être en outre maintenu dans n'importe quelle position intermédiaire entre sa position d'équilibre et sa position de plus grande déflexion, par rapport à l'équilibre.

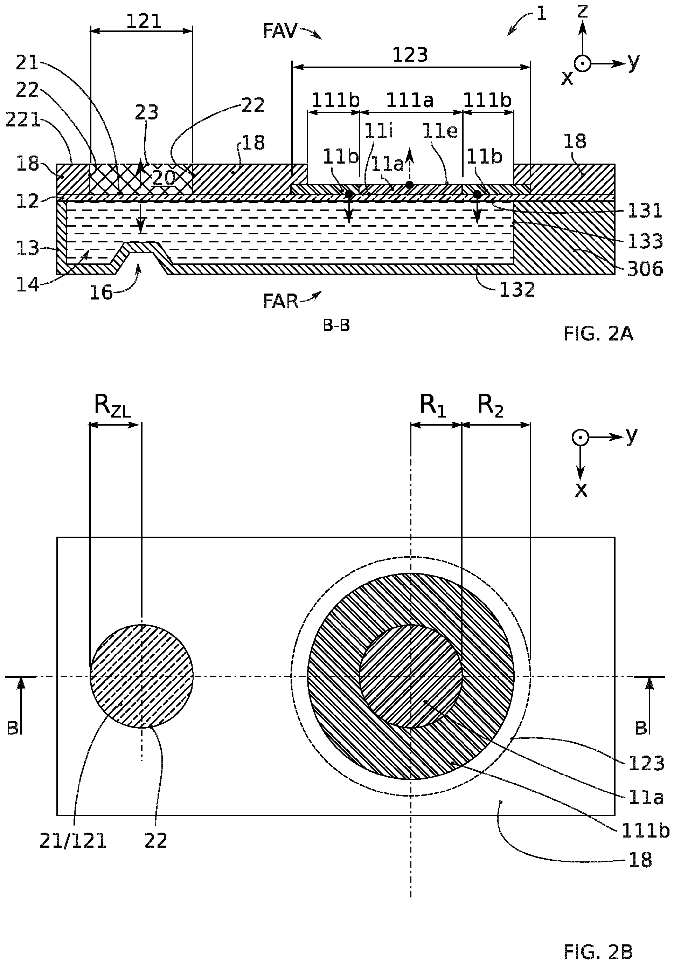

Dans les exemples illustrés sur les figures 1A et 2A, on peut considérer que, lorsque le transducteur électromécanique 11, 11a, 11b n'est pas sollicité, sa partie mobile 111, 111a, 111b s'étend principalement dans un plan parallèle au plan xy du repère orthogonal xyz.

Au moins un, voire chaque transducteur électromécanique 11, 11a, 11b est de préférence un transducteur piézoélectrique. Chaque transducteur électromécanique 11 comprend au moins un matériau piézoélectrique mécaniquement couplé à un autre élément, qualifié de support ou de poutre. Le terme de poutre ne limite aucunement la forme de cet élément.

De façon connue, un matériau piézoélectrique présente comme propriété de se contraindre lorsqu'on lui applique un champ électrique. En se contraignant, il se déforme. Mécaniquement associé au support, le matériau piézoélectrique entraine le support avec lui et déplace alors ce dernier. La zone du support susceptible de se déplacer correspond à la partie mobile 111, 111a, 111b du transducteur électromécanique 11, 11a, 11b. C'est cette propriété de déplacement qui est utilisée pour former un actionneur.

De même, sous l'action d'une contrainte mécanique, un matériau piézoélectrique se polarise électriquement. Ainsi, lorsque le support est déplacé, il déforme le matériau piézoélectrique qui induit un signal électrique. C'est cette propriété qui est utilisée pour former un capteur.

Il ressort donc de cet exemple, mais cela reste potentiellement vrai pour chacun des autres modes de réalisation envisagés du transducteur électromécanique 11, 11a, 11b, que le microsystème électromécanique 1 selon l'invention peut fonctionner comme dispositif de préhension et/ou comme capteur.

Au moins un, voire chaque transducteur électromécanique 11, 11a, 11b est encore plus préférentiellement un transducteur piézoélectrique comprenant un matériau piézoélectrique à base de PZT (Titano-Zirconate de Plomb). Dans ce cas, la partie mobile 111, 111a, 111b du transducteur électromécanique 11, 11a, 11b est capable sous sollicitation de se mouvoir avec un déplacement plus significatif (du fait du coefficient piézoélectrique d31) qu'avec bon nombre d'autres matériaux piézoélectriques. Toutefois, le PZT étant un matériau ferroélectrique, un tel transducteur piézoélectrique fonctionne préférentiellement dans un seul sens d'actionnement (mouvement dans un unique sens de sa partie mobile 111, 111a, 111b) quelle que soit la polarité de son alimentation électrique, alors qu'un transducteur piézoélectrique à base d'un matériau nonferroélectrique peut préférentiellement fonctionner dans les deux sens (mouvement dans deux sens opposés de sa partie mobile 111, 111a, 111b). En alternative ou en complément, au moins un, voire chaque transducteur électromécanique 11, 11a, 11b peut être un transducteur piézoélectrique (non ferroélectrique) à base d'un matériau propre à permettre à sa partie mobile 111, 111a, 111b de se mouvoir dans des sens opposés relativement à sa position d'équilibre, par exemple en fonction de la polarité de son alimentation électrique. Un tel matériau est par exemple un matériau à base de nitrure d'aluminium (AIN).

### Membrane déformable 12

La membrane déformable 12 peut être à base d'un polymère, et est de préférence à base de PDMS (pour polydiméthylsiloxane). Les propriétés de la membrane déformable 12 en particulier son épaisseur, sa surface et sa forme peuvent être configurées pour conférer à la membrane déformable 12, et plus particulièrement à la zone 121 de cette membrane qui est libre de se déformer, une capacité d'étirement escomptée, notamment en fonction de l'application visée.

### Première cavité 13

La première cavité 13 telle qu'illustrée notamment sur les figures 1A et 2A présente plus particulièrement des parois 131, 132, 133 contenant hermétiquement le milieu déformable 14. Dans les exemples illustrés, la paroi 132 de la première cavité 13 constitue la face arrière FAR du microsystème électromécanique 1. La paroi 131 opposée à la paroi 132 est formée au moins en partie par au moins une partie de la membrane déformable 12. Ainsi, la paroi 131 est déformable. La paroi 131 est parfois désignée par la suite première paroi de la première cavité 13. Elle se situe au niveau de la face avant FAV du microsystème électromécanique 1. Au moins une paroi 133 latérale joint entre elles les parois 131 et 132. On notera que l'herméticité de la première cavité 13 nécessite que la membrane déformable 12 soit elle-même imperméable, ou rendue imperméable, notamment au niveau de sa zone libre 121. De préférence, les parois 132, 133 restent fixes lorsque la membrane se déforme.

Le milieu déformable 14 est quant à lui propre à conserver un volume sensiblement constant sous l'action d'un changement de pression externe. Autrement dit, il peut s'agir d'un milieu incompressible ou faiblement compressible dont la déformation nécessite de préférence peu d'énergie. Il s'agit par exemple d'un liquide.

Du fait qu'une partie au moins de la première paroi 131 de la première cavité 13 est formée par une partie au moins de la membrane déformable 12, l'on comprend que tout changement de pression externe exercée sur le milieu déformable 14 peut être compensé par une déformation, sensiblement proportionnelle, de la membrane déformable 12, et plus particulièrement de sa zone libre 121 et/ou par un déplacement de la partie mobile 111, 111a, 111b d'au moins un transducteur électromécanique 11, 11a, 11b. Lorsqu'un transducteur est sollicité, cette compensation est plus particulièrement liée à une conversion du changement de pression externe exercée sur le milieu déformable 14 en un étirement de la membrane déformable 12 ou une relaxation de la membrane déformable 12 déjà étirée. On rappelle que le milieu déformable 14 est incompressible et que ces contraintes s'effectuent donc avec une conservation du volume de la première cavité 13. L'on comprend que, dans un souci de reproductibilité de l'actionnement ou de la captation de mouvement qu'offre le microsystème électromécanique 1 selon l'invention, il est préférable que toute déformation de la membrane déformable 12 soit élastique, et non plastique, pour garantir le retour dans un même état de moindre étirement, ou de relaxation maximale, de la membrane déformable 12 chaque fois qu'elle n'est plus contrainte.

Comme illustré sur chacune des figures 1A et 2A, chaque transducteur électromécanique 11, 11a, 11b peut former une partie de la première paroi 131 de la première cavité 13. Chaque transducteur électromécanique 11, 11a, 11b et la membrane déformable 12 sont ainsi placés d'un même côté de la première cavité 13. Les structures présentant cette caractéristique sont avantageusement non traversantes, comme évoqué plus haut.

Sur ces exemples non limitatifs, la membrane 12 présente une face interne 12i configurée pour être au contact du milieu déformable 14 et une face externe 12e. La face interne 12i forme au moins une partie de la première paroi 131 de la première cavité 13. Chaque transducteur électromécanique 11, 11a, 11b présente une face interne 11i tournée au regard, et de préférence au contact de la face externe 12e de la membrane 12. Chaque transducteur électromécanique 11, 11a, 11b présente également une face externe 11e, opposée à la face interne 11i, et tournée vers l'extérieur du microsystème électromécanique 1. Alternativement, on peut prévoir qu'une ou des couches intermédiaires soient disposées entre la face externe 12e de la membrane 12 et la face interne 11i de chaque transducteur électromécanique. Le microsystème électromécanique 1 est configuré de sorte que le mouvement de la partie mobile 111, 111a, 111b de chaque transducteur électromécanique 11, 11a, 11b provoque une déformation de la zone libre 121 de la membrane 12 et donc de la première paroi 131 qui enferme le milieu 14.

On remarquera que, sur chacune des figures 1A et 2A, la membrane déformable 12 sépare chaque transducteur électromécanique 11, 11a, 11b du milieu déformable 14.

En outre, chaque transducteur électromécanique 11 ou chaque couple de transducteurs électromécaniques 11a et 11b peut avantageusement être solidaire de la membrane déformable 12 sur une zone 123 de sorte que tout mouvement de la partie mobile 111, 111a, 111b de chaque transducteur électromécanique 11, 11a, 11b induise, notamment sur cette zone 123, un étirement ou une relaxation de la membrane déformable 12. Ainsi, dans l'exemple illustré sur la figure 2A, lorsque le premier transducteur électromécanique 11a est sollicité de sorte à se déplacer vers le haut (comme illustré par la flèche en tirets s'étendant depuis la partie mobile 111a du premier transducteur électromécanique 11a), une diminution de la pression externe exercée sur le milieu déformable 14 est observée, qui induit l'étirement de la membrane déformable 12 vers le bas, i.e. vers le centre de la première cavité 13.

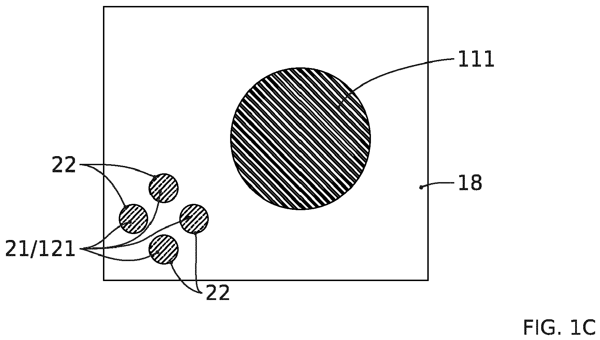

Comme illustré sur les figures 1B, 1C et 2B, la zone 123 sur laquelle s'étend chacun des transducteurs électromécaniques 11, 11a et 11b est située hors de la zone libre 121. Elle peut également être adjacente à la zone libre 121. Elle peut encore délimiter la zone 121, par exemple en l'entourant partiellement ou complètement.

### Milieu déformable 14

Le milieu déformable 14 peut plus particulièrement comprendre au moins l'un parmi un fluide et/ou un liquide. Les paramètres du milieu déformable 14 seront adaptés en fonction des applications visés. L'on s'assure ainsi que tout changement de pression externe exercée sur le milieu déformable 14 induise une déformation sensiblement proportionnelle de la zone libre 121 de la membrane déformable 12. Le milieu déformable 14 peut être constitué ou à base d'un liquide, tel que de l'huile, ou peut être constitué ou à base d'un polymère. Selon un exemple, le milieu déformable 14 est à base ou est constitué de glycérine. L'on s'assure ainsi, en plus d'une déformation sensiblement proportionnelle de la membrane 12, de la capacité du milieu déformable 14 à occuper notamment le volume créé par étirement de la zone libre 121 de la membrane déformable 12 à l'opposé du centre de la première cavité 13.

Lorsque le microsystème électromécanique 1 joue le rôle de dispositif de préhension, au moins un transducteur électromécanique 11, 11a, 11b est sollicité de sorte à exercer un changement de pression externe sur le milieu déformable 14 et induire par-là la déformation de la membrane déformable 12. Inversement, lorsque le microsystème électromécanique 1 joue le rôle de capteur, la déformation de la membrane 12 exerce un changement de pression externe sur le milieu déformable 14 qui induit un déplacement de la partie mobile 111, 111a, 111b d'au moins un transducteur électromécanique 11, 11a, 11b et génère par voie de conséquence un signal électrique.

Le pourtour externe de la zone libre 121 et/ou du transducteur 11 illustré sur la figure 1A et/ou de l'ensemble de deux transducteurs 11a, 11b tel qu'illustré sur la figure 2A, peut par exemple être défini par un capot 18 qui maintient la membrane 12. La membrane 12 est ainsi située entre le capot 18 et le milieu déformable 14. Ce capot 18 s'étend par exemple dans le plan xy. Il présente au moins une ouverture qui définit la zone libre 121. Le capot 18 peut s'étendre sur toute la surface de la première cavité 13, en projection sur le plan xy, à l'exception d'une ouverture définissant la zone libre 121 de la membrane 12 et d'au moins une autre ouverture correspondant sensiblement à la zone 123 dans laquelle est logé le transducteur électromécanique 11 ou l'ensemble de deux transducteurs 11a, 11b. Le capot 18 peut présenter une zone qui sépare ces deux ouvertures.

### Agencement de la zone libre 121

Dans les modes de réalisation illustrés aux figures 1A, 1B, 1C, 2A et 2B, la zone libre 121 est séparée du transducteur électromécanique 11 ou de l'ensemble de transducteurs 11a et 11b. Ainsi, une distance non nulle sépare la zone libre 121 et chaque transducteur électromécanique 11, 11a, 11b. Cette distance non nulle est par exemple au moins en partie matérialisée par le capot 18, comme illustré en figure 2B.

Selon d'autres modes de réalisation non illustrés sur les figures, la zone libre 121 peut être entourée, au moins partiellement, par au moins un transducteur électromécanique 11, 11a, 11b. Toutefois, dans ce cas, on s'assurera que la configuration du microsystème électromécanique 1 n'est pas telle que le volume de la deuxième cavité 20 ne varie pas quel que soit le changement de position du ou des transducteurs électromécaniques 11, 11a et 11b.

Plus précisément, dans l'exemple illustré sur les figures 2A et 2B, le premier transducteur électromécanique 11a a la forme d'un disque de rayon R1 et le deuxième transducteur électromécanique 11b a la forme d'un anneau s'étendant dans une zone d'étendue radiale R2 autour du disque formé par le premier transducteur électromécanique 11a.

De préférence, la somme du rayon R1 du disque formé par le premier transducteur électromécanique et de l'étendue radiale R2 de l'anneau formé par le deuxième transducteur électromécanique est inférieure à 900 µm, de préférence inférieure à 600 µm, et encore plus préférentiellement inférieure à 300 µm.

Le rayon R1 du disque formé par le premier transducteur électromécanique 11a peut être au minimum de 20 µm, et l'étendue radiale R2 de l'anneau formé par le deuxième transducteur électromécanique 11b peut être au minimum de 10 µm.

En complément ou en alternative, l'étendue radiale R2 de l'anneau formé par le deuxième transducteur électromécanique 11b peut être environ deux fois plus petite que le rayon R1 du disque formé par le premier transducteur électromécanique 11a.

En complément ou en alternative à l'un quelconque des deux exemples précédents, ledit au moins un premier transducteur électromécanique et ledit au moins un deuxième transducteur électromécanique s'inscrivent étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie. Ledit au moins un premier transducteur électromécanique s'inscrit plus particulièrement dans la première partie de la zone circulaire et ledit au moins un deuxième transducteur électromécanique s'inscrit plus particulièrement dans la seconde partie de la zone circulaire. La première partie de la zone circulaire présente un rayon R_{2/3} sensiblement égale aux deux tiers du rayon total et la seconde partie de la zone circulaire présente une étendue radiale E_{1/3} sensiblement égale au tiers du rayon total.

Le disque 11a et l'anneau 11b sont de préférence concentriques.

Le disque 11a et l'anneau 11b peuvent être, comme représentés, adjacents entre eux, l'anneau 11b présentant alors une étendue radiale égale à R2.

L'étendue radiale R2 de la zone s'étendant autour du disque 11a est par exemple comprise entre quelques dizaines et quelques centaines de microns, et typiquement égale à 100 microns pour un rayon total de l'ordre de 300 µm.

On comprend ici que chaque transducteur électromécanique 11a, 11b comprenant une partie mobile 111a, 111b qui lui est propre, la partie mobile d'un des deux transducteurs 11a et 11b peut être sollicitée indépendamment, et notamment alternativement, à la partie mobile de l'autre des deux transducteurs 11a et 11b.

Dans une configuration selon laquelle, R1 est sensiblement égal au 2/3 de R1+R2 et R2 est sensiblement égal au 1/3 de R1+R2, la déformation de la partie mobile 111a du premier transducteur électromécanique 11a est antagoniste, et plus particulièrement dans un sens opposé dans la direction de l'axe z, à la déformation de la partie mobile 111b du deuxième transducteur électromécanique 11b. Il est alors possible, même lorsque chacun des deux transducteurs 11a et 11b comprend un transducteur piézoélectrique à base de PZT, d'induire alternativement, en fonction de celui des deux transducteurs 11a et 11b qui est sollicité, un éloignement et un rapprochement de la zone libre 121 de la membrane 12 relativement à au moins une paroi parmi les parois 132, 133 de la première cavité 13. Par exemple, le premier transducteur électromécanique 11a est configuré pour se mouvoir vers le haut, i.e. à l'opposé du centre de la première cavité 13, lorsqu'il est sollicité, et le deuxième transducteur électromécanique 11b est configuré pour se mouvoir vers le bas, i.e. vers le centre de la première cavité 13, lorsqu'il est sollicité.

Notons qu'aucun des transducteurs électromécaniques 11, 11a et 11b n'est limité à une forme à symétrie de révolution, mais peut prendre d'autres formes, et notamment une forme oblongue ou ovale, une forme triangulaire, rectangulaire, etc.

Dans le cas illustré sur la figure 1A et où le transducteur électromécanique 11 est un transducteur piézoélectrique comprenant un matériau piézoélectrique à base de PZT, il est intéressant que la partie mobile 111 du transducteur électromécanique 11 présente une surface au moins deux fois, voire quatre fois, et même dix fois, supérieure à la surface de la zone libre 121 de la membrane déformable 12. La membrane déformable 12 est dès lors configurée de sorte que sa zone libre 121 est capable de se déformer avec une amplitude d'au moins 50 µm, d'environ 100 µm, voire de plusieurs centaines de µm.

De manière générale, la membrane déformable 12 est configurée de sorte que sa zone libre 121 est capable de se déformer avec une amplitude inférieure à 1mm. Cette déformation est mesurée selon une direction perpendiculaire au plan dans lequel s'étend principalement la face externe 12e de la membrane 12 au repos. Sans se déchirer et/ou sans usure significative, le microsystème électromécanique 1 permet une amplification hydraulique de l'action et offre ainsi la capacité à satisfaire de nombreuses et diverses applications nécessitant un grand débattement, ou équivalemment de grandes variations du volume de la deuxième cavité 20. Dans ce contexte, le microsystème électromécanique 1 illustré sur les figures 3A à 3C et 4A à 4B peut être défini comme dispositif de préhension à grandes variations de force.

Egalement lorsque le recouvrement partiel de la membrane déformable 12 par le transducteur électromécanique 11 est tel qu'illustré sur les figures 1A et 1B et que le transducteur électromécanique 11 est un transducteur piézoélectrique comprenant un matériau piézoélectrique à base de PZT, le rayon R_{ZL} de la zone libre 121 de la membrane déformable 12 peut être sensiblement égal à 100 µm et l'étendue radiale R1 du transducteur électromécanique 11 (typiquement son rayon s'il est circulaire) peut être sensiblement égal à 350 µm. Les références R_{ZL} et R1 sont illustrées en figure 1B.

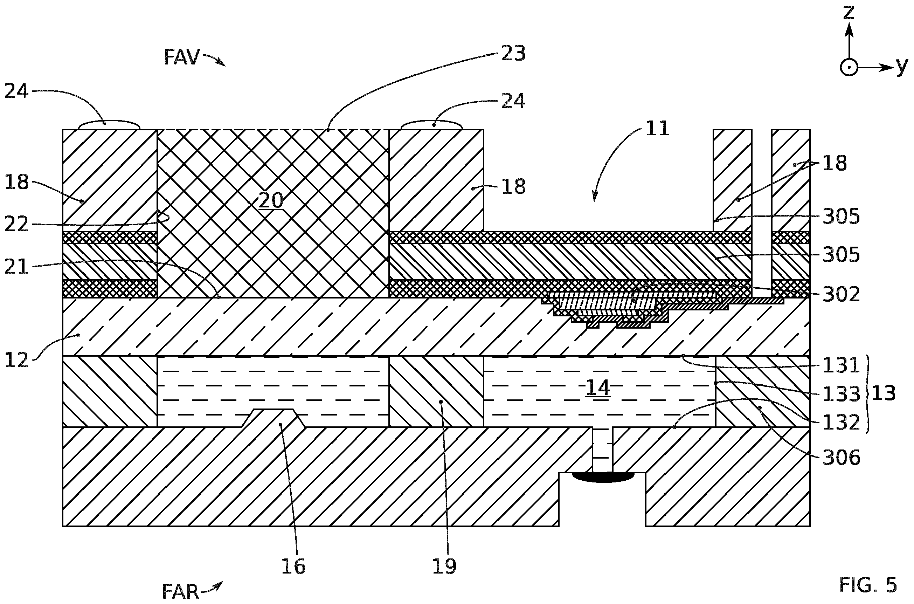

Comme mentionné plus haut, le transducteur électromécanique 11 peut comprendre plus particulièrement un élément constituant une poutre 305 et un élément piézoélectrique 302 à base de PZT, ce dernier étant configuré pour induire une déflexion de la poutre 305 (Cf. figure 5). L'épaisseur de l'élément piézoélectrique 302 peut être sensiblement égale à 0,5 µm et l'épaisseur de la poutre 305 est par exemple comprise entre quelques microns et plusieurs dizaines de microns, par exemple 5 µm. Dans une telle configuration, lorsque le rayon du transducteur électromécanique 11 est supérieur à 100 microns, voire supérieure à 200 microns, l'amplitude de déplacement de la partie mobile 111 du transducteur 11 peut atteindre une valeur égale à quelques dizaines de microns, en particulier lorsque le transducteur 11 est parcouru par une tension électrique égale à quelques dizaines de volt. Plus particulièrement, dans une telle configuration, la partie mobile 111 du transducteur électromécanique 11 peut être déplacée ou défléchie avec une amplitude par exemple sensiblement égale à 15 µm en étant parcouru par une tension électrique par exemple sensiblement égale à 10 V.

L'invention n'est toutefois pas limitée aux différentes valeurs spécifiques données ci-dessus qui peuvent être largement adaptées, en fonction de l'application visée, notamment pour trouver un compromis entre facteur d'étirement et amplitude de déformation attendue de la zone libre 121 de la membrane déformable 12.

A noter que, dans sa position d'équilibre, la partie mobile 111 du transducteur électromécanique 11, et plus généralement le transducteur électromécanique 11, peut ne pas être plat, mais peut au contraire présenter une déflexion dite déflexion à l'équilibre qui n'enlève rien, en termes d'amplitude, à la capacité de déplacement ou de déflexion du transducteur électromécanique 11 alimenté électriquement.

### Deuxième cavité 20

La deuxième cavité 20 va maintenant être décrite notamment en référence à chacune des figures 1A et 2A.

La deuxième cavité 20 est déformable. Elle présente un volume variable délimité par des parois 21, 22 et une ouverture 23. Sur chacune des figures 1A et 2A, la paroi 22 s'étend depuis la première cavité 13 jusqu'à une extrémité distale 221. L'ouverture 23 est formée par l'extrémité distale 221 de la paroi latérale 22. En figure 1A, l'extrémité distale 221 est représentée pour illustrer le mode dans lequel la paroi 22 est formée en partie par le capot 18 décrit ci-dessous.

Plus particulièrement, au moins une partie d'une première paroi 21 prises parmi lesdites parois 21, 22 de la deuxième cavité 20 est formée d'au moins une partie de ladite au moins une zone libre 121 de la membrane 12. Ainsi, et notamment dans chacun des deux modes de réalisation illustrés sur les figures, un changement de pression externe dans la première cavité 13 induit une variation du volume de la deuxième cavité 20, ou inversement une variation du volume de la deuxième cavité 20 induit un changement de pression externe dans la première cavité 13.

Encore plus particulièrement, comme illustré sur chacune des figures 1A et 2A, la face interne 12i de la membrane 12 forme au moins une partie de la première paroi 131 de la première cavité 13 et la face externe 12e de la membrane forme au moins une partie de la première paroi 21 de la deuxième cavité 20.

La première paroi 21 de la deuxième cavité 20 peut être formée d'une partie seulement de la zone libre 121 de la membrane 12. La deuxième cavité 20 comprend alors une paroi latérale 22 s'étendant depuis ladite au moins une zone libre 121 de la membrane 12. La paroi latérale 22 définit alors l'étendue de la première paroi 21 de la deuxième cavité 20 relativement à l'étendue de la zone libre 121 de la membrane 12. Dans ce cas, les parois 21 et 22, ainsi que l'ouverture 23, de la deuxième cavité 20 sont déplacées, en particulier selon la direction z illustrée sur les figures 1A et 2A, lorsque la zone libre 121 de la membrane 12 est déformée. Le microsystème selon cette particularité peut permettre d'accommoder la mise en contact entre la deuxième cavité 20 et un objet 3 destiné à obstruer la deuxième cavité 20. Ainsi, l'on diminue le risque d'endommagement, voire d'arrachement, de la zone libre 121 de la membrane 12 lors de ladite mise en contact. Notons que la variation de volume de la deuxième cavité 20 est due dans ce cas à la déformation de la seule portion de la zone libre 121 qui définit l'étendue de la première paroi 21 de la deuxième cavité 20.

Par ailleurs, la zone sur laquelle s'étend la première paroi 21 de la deuxième cavité 20 peut être exempte de toute partie mobile 111, 111a, 111b d'un transducteur électromécanique 11, 11a, 11b, comme illustré sur les figures. Toutefois, l'invention n'est pas limitée à une telle exemption. En particulier, une partie au moins des parois 21, 22 de la deuxième cavité 20 peut comprendre au moins la partie mobile 111, 111a, 111b d'un transducteur électromécanique 11, 11a, 11b pour peu que la configuration du microsystème électromécanique 1 n'est pas telle que le volume de la deuxième cavité 20 ne varie pas quel que soit le changement de position du ou des transducteurs électromécaniques 11, 11a et 11b.

La deuxième cavité 20 comprend, parmi ces parois 21, 22, une paroi latérale 22 s'étendant depuis un pourtour de sa première paroi 21 à l'opposé de la première cavité 13. La paroi latérale 22 est de préférence pleine et indéformable relativement à la capacité de déformation de la zone libre 121 de la membrane déformable 12.

Sur les figures 1A et 2A, un capot 18 est illustré. La paroi latérale 22 de la deuxième cavité 20 peut en effet être définie, dans l'épaisseur du capot 18, par une ouverture pratiquée dans le capot 18 pour définir la zone libre 121. Notons en outre que l'on peut prévoir que la zone libre 121 de la membrane 12 soit configurée conjointement avec un ou plusieurs transducteurs électromécaniques pour se déformer uniquement vers le centre de la première cavité. Ainsi, les variations de volume de la deuxième cavité ne sont pas nécessairement limitées à des variations inférieures au volume défini par la face externe 12e de la membrane déformable au repos et l'ouverture pratiquée dans le capot 18 pour définir la zone 121.

Il est toutefois avantageux que la deuxième cavité 20 comprenne une paroi latérale 22 s'étendant depuis un pourtour de sa première paroi 21 à l'opposé de la première cavité 13, le cas échéant au-delà même de l'épaisseur du capot 18. L'on s'assure ainsi de conférer à la deuxième cavité 20 un volume s'étendant potentiellement significativement à la fois d'un côté et/ou de l'autre de la première paroi 131 de la première cavité 13. Une telle paroi latérale 22 permet ainsi, en fonction de son étendue, de définir une deuxième cavité 20 présentant un volume suffisant et paramétrable lorsque la zone libre 121 de la membrane 12 est au repos. Toutes variations de volume souhaitées en fonction de l'application visée sont ainsi atteignables.

Plus particulièrement, la paroi latérale 22 permet de par sa forme et/ou ses dimensions de définir un volume de la deuxième cavité 20 plus ou moins grand, lorsque la zone libre 121 de la membrane 12 est au repos, offrant ainsi une large capacité d'adaptation de la variation de volume atteinte pour des applications variées.

Le capot 18 peut être conformé pour former ou pour prolonger latéralement la paroi latérale 22. Le capot 18 peut ainsi former une partie de la cavité 20. En alternative, la paroi latérale 22 peut s'étendre depuis le capot 18, à l'opposé du centre de la cavité 13. Notons ici que la fonction principale du capot 18 est de contribuer à mettre en prise la partie non mobile d'au moins un transducteur électromécanique, pour mieux s'assurer de son immobilité ; il s'étend alors, comme illustré sur les figures 1A et 2A notamment, sur la partie non mobile du transducteur 11 et/ou sur la partie non mobile de l'ensemble des deux transducteurs 11a et 11b. Nous verrons plus bas que cette contribution à la mise en prise de la partie non mobile d'au moins un transducteur électromécanique par le capot 18 peut être complétée par un espaceur 306 ou une entretoise 19, situé à l'opposé du capot 18 relativement à ladite partie non mobile.

Le microsystème électromécanique 1 selon l'invention peut comprendre en outre une couche souple 24 (illustrée sur les figures 3A à 3C et 4A à 4B, ainsi que sur la figure 5) configurée pour être intercalée entre au moins l'une des parois 21, 22 de la deuxième cavité 20 et une partie de l'objet 3 obstruant la deuxième cavité 20. La couche souple 24 est par exemple à base d'un matériau choisi parmi le silicone et le parylène. Elle a pour objet d'une part d'amortir le cas échéant la mise en contact entre l'ouverture 23 de la deuxième cavité 20 et un objet 3 venant obstruer cette ouverture 23, d'autre part d'assurer l'étanchéité de la deuxième cavité 20 au niveau du contact entre la deuxième cavité 20 et l'objet 3.

L'on comprend qu'une telle couche souple 24 n'est pas nécessairement requise lorsque le microsystème électromécanique 1 constitue tout ou partie d'un microbaromètre.

En outre, le microsystème électromécanique 1 peut comprendre, comme illustré sur la figure 1C, une pluralité de deuxièmes cavités 20 séparées les unes des autres d'une distance non nulle.

Lorsque plusieurs deuxièmes cavités 20 s'étendent depuis une même paroi 131 de la première cavité 13, comme illustré sur la figure 1C, chacune de ces deuxièmes cavités 20 peut être configurée pour concourir au maintien et au relâchement d'un objet 3 les obstruant. Il est ainsi permis de répartir les forces s'exerçant sur l'objet 3 en différents endroits de l'objet ou sur différentes surfaces de l'objet. Ces différentes surfaces ne sont pas nécessairement comprises dans un même plan ni ne sont nécessairement parallèles entre elles, de telles variations pouvant être accommodées par les formes et/ou les dimensions des parois latérales 22 des deuxièmes cavités 20, et plus particulièrement par les formes et/ou les dimensions de leurs extrémités distales 221.

En outre, le microsystème électromécanique est ainsi rendu résilient à un éventuel dysfonctionnement d'une deuxième cavité 20, voire de plusieurs deuxièmes cavités ; en effet, une multitude de deuxièmes cavités 20 permet de limiter les risques de perte d'étanchéité est ainsi la perte du différentiel de pression permettant l'aspiration ou l'expulsion de l'objet.

Par ailleurs, les conditions de placement de l'objet 3 relativement au microsystème 1 afin que l'objet 3 puisse être maintenu peuvent être relâchées. Par exemple, si l'objet 3 n'est reporté qu'en regard d'une partie des deuxièmes cavités de la pluralité, son maintien et/ou son expulsion est tout de même susceptible d'être assuré.

Par ailleurs, que plusieurs deuxièmes cavités 20 s'étendent depuis une même paroi de la première cavité 13 ou depuis des parois différentes entre elles de la première cavité 13, le microsystème 1 peut ainsi permettre de maintenir et relâcher une pluralité d'objets 3, chaque objet obstruant au moins une deuxième cavité 20 de la pluralité.

L'extrémité distale 221 de la paroi latérale 22 de chaque deuxième cavité 20 peut être conformée à la forme d'un objet 3 destiné à obstruer l'ouverture 23, et plus particulièrement à une zone spécifique de cet objet 3. Il est ainsi possible de s'assurer d'un positionnement déterminé, notamment en termes d'orientation, de l'objet saisi.

### Butée basse

Comme illustré sur chacune des figures 2A et 5, le microsystème électromécanique 1 peut comprendre en outre une ou plusieurs butées de fin de course, dites butées basses 16. Cette ou ces butées basses 16 sont supportées par la paroi 132 de la première cavité 13 qui est opposée à la paroi 131 formée au moins en partie par la membrane déformable 12. Elle s'étend dans la première cavité 13 vers la zone libre 121 de la membrane déformable 12. Cette butée basse 16 présente de préférence une forme et des dimensions configurées pour limiter la surface de contact entre la membrane 12 et la paroi 132 de la cavité 13 opposée à la zone libre 121 de la membrane 12 déformable. Cela permet d'éviter que la membrane 12 n'adhère et ne se colle à cette paroi 132.

### Mode de réalisation des figures 3A à 3C

En référence aux figures 3A à 3C, un premier mode de fonctionnement du microsystème 1 selon son premier mode de réalisation va maintenant être décrit.

Le transducteur électromécanique 11 illustré sur les figures 3A à 3C est configuré de sorte à induire alternativement une diminution et une augmentation du volume de la deuxième cavité 20.

Comme illustré sur la figure 3A, un objet 3 peut être reporté sur le microsystème 1 de sorte à obstruer l'ouverture 23 de la deuxième cavité 20, lorsque la zone libre 121 de la membrane 12 n'est pas déformée.

Comme illustré sur la figure 3C, le transducteur électromécanique 11 peut être sollicité de sorte à être défléchi, comme indiqué par la flèche, dans une direction opposée au centre de la première cavité 13. Ce changement de position du transducteur 11 induit alors une déformation de la zone libre 121 de la membrane 12 vers le centre de la première cavité 13. Le volume de la deuxième cavité 20 s'en trouve augmenter. Par voie, la pression à l'intérieur de la deuxième cavité 20 est diminuée relativement à la pression ambiante. Un différentiel de pression est ainsi créé qui tend à maintenir l'objet 3 sur le microsystème 1.

Lorsque le sens de la déflexion du transducteur 11 peut être inversé, comme illustré sur la figure 3B, le changement de position du transducteur 11 induit alors une déformation de la zone libre 121 de la membrane 12 à l'opposé du centre de la première cavité 13. Le volume de la deuxième cavité 20 s'en trouve diminué. Par voie, la pression à l'intérieur de la deuxième cavité 20 est augmentée relativement à la pression ambiante. Un différentiel de pression est ainsi créé qui tend à expulser l'objet 3 depuis le microsystème 1.

Ce fonctionnement du microsystème selon le premier mode de réalisation de l'invention peut être obtenu en considérant un unique transducteur électromécanique à base d'un matériau propre à permettre à la partie mobile 111, 111a, 111b du transducteur électromécanique de se mouvoir dans des sens opposés relativement à sa position d'équilibre, par exemple en fonction de la polarité de son alimentation électrique. Comme déjà énoncé plus haut, un tel matériau est par exemple un matériau à base de nitrure d'aluminium (AIN).

Le même fonctionnement peut être obtenu en considérant au moins deux transducteurs électromécaniques 11a et 11b, chacun à base d'un matériau propre à permettre à la partie mobile 111a, 111b du transducteur électromécanique auquel il appartient de se mouvoir dans un unique relativement à sa position d'équilibre. Le premier transducteur électromécanique 11a peut prendre la forme d'un disque de rayon noté R1et le second transducteur électromécanique 11a peut prendre la forme d'un anneau d'étendue radiale notée R2 (Cf. Fig. 2B). L'étendue radiale R2 de l'anneau formé par le second transducteur électromécanique 11b sera alors choisie environ deux fois plus petite que le rayon R1 du disque formé par le premier transducteur électromécanique 11a.

### Mode de réalisation des figures 4A à 4B

En référence aux figures 4A et 4B, un deuxième mode de fonctionnement du microsystème 1 selon son premier mode de réalisation va maintenant être décrit.

Dans ce deuxième mode de fonctionnement, l'objet 3 n'est plus supporté, mais porté, par le microsystème 1. Auquel cas, il est avantageux que le microsystème 1 soit reporté sur l'objet 3 dans une configuration où le transducteur 11 est défléchi vers le centre de la première cavité 13, de sorte que la zone libre 121 de la membrane 12 soit déformée dans une direction opposée au centre de la première cavité 13 et réduise le volume de la deuxième cavité 20. À ce moment, la pression à l'intérieur de la deuxième cavité 20 est sensiblement égale à la pression ambiante. La déflexion du transducteur 11 est liée à sa sollicitation, en particulier par application d'une tension électrique. Lorsque la sollicitation du transducteur 11 est subséquemment diminuée ou annulée, le transducteur 11 reprend sa position hors sollicitation par un mouvement dans une direction opposée au centre de la première cavité 13. La zone libre 121 de la membrane 12 s'en trouve mue vers le centre de la première cavité 13. Ainsi, le volume de la deuxième cavité 20 est augmenté, et la pression à l'intérieur de la cavité 20 est diminuée relativement à la pression ambiante. Un différentiel de pression a ainsi été créé qui permet de maintenir, voire de porter, l'objet 3, alors même que le transducteur 11 n'est plus sollicité.

Envisageons le cas particulier dans lequel l'objet 3 est à base de silicium et prend la forme d'un parallélépipède de grandes surfaces sensiblement égales à 100 cm² et d'une épaisseur de 700 microns. Dans des conditions normales de pesanteur et de pression atmosphérique, le poids de cet objet 3 est d'environ 1,59 mN. Il est nécessaire afin que le microsystème 1 permette de porter l'objet 3, que la force de contre-pression qu'exerce sur l'objet 3 le différentiel de pression susmentionné soit supérieure au poids de l'objet 3. Considérant, toujours dans le cas particulier envisagé, une deuxième cavité 20 prenant une forme sensiblement cylindrique de rayon R égal à 100 microns et d'une hauteur H égale à 200 microns, le volume de la deuxième cavité 20 a une valeur sensiblement égale à 8.10⁻¹² m³, lorsque la zone libre 121 de la membrane 12 n'est pas déformée, hors une variation de volume de 4.10⁻¹² m³, soit la moitié de 8.10⁻¹² m³, permet de créer, par rapport à la pression ambiante égale à la pression atmosphérique, un différentiel de pression exerçant sur l'objet 3 obstruant la deuxième cavité 20 une force de contre-pression sensiblement égale à 3,56 mN, supérieure à 1,59 mN, c'est-à-dire une force de contre-pression permettant de s'opposer relativement confortablement au poids de l'objet 3. Il va de soi, notamment au vu des illustrations annexées, qu'une variation pour moitié du volume de la deuxième cavité 20 est tout à fait atteignable.

Le microsystème 1 permet ainsi le maintien de l'objet 3, y compris lorsque l'objet 3 ne repose pas sur le microsystème 1, c'est-à-dire lorsque son poids n'est pas supporté par le microsystème 1. Le microsystème 1 est ainsi propre à venir saisir par le dessus (relativement à la force de pesanteur) un objet 3 d'un certain poids déterminé, à le maintenir un temps déterminé, par exemple le temps de déplacer l'objet depuis sa position initiale jusqu'à une autre position (et sans que cela ne nécessite une sollicitation notamment électrique du transducteur électromécanique 11), puis à relâcher l'objet 3, par exemple une fois celui-ci parvenu à destination. Le microsystème 1 trouve ici à s'appliquer particulièrement avantageusement dans les machines dites de type « pick-and-place ».

Un mode de réalisation de l'invention plus spécifique que ceux décrits ci-dessus est illustré sur la figure 5 sur laquelle les mêmes références que sur la figure 1A référencient les mêmes objets.

On y observe tout d'abord que le transducteur électromécanique 11 illustré comprend un support 305 également désigné poutre et un matériau piézoélectrique 302 configuré pour déformer la poutre 305 lorsqu'une tension électrique lui est appliquée. Le terme poutre 305 ne limite pas la forme de ce support. Dans cet exemple, la poutre 305 forme un disque. Le capot 18 ou la première cavité 13 du microsystème électromécanique 1 est destiné à être fixé sur un support ou un bâti.

Le matériau piézoélectrique 302 y est situé au-dessous du matériau constituant la poutre 305 ou équivalemment au-dessous de la fibre neutre du transducteur 11. Comme cela apparaîtra clairement à la vue de la description ci-dessous du procédé de fabrication du microsystème illustré sur la figure 5, notons ici qu'il est aisé d'obtenir une configuration inverse dans lequel le matériau piézoélectrique 302 serait situé au-dessus du matériau constituant la poutre 305 ou équivalemment au-dessus de la fibre neutre du transducteur 11. C'est grâce à cette alternative qu'un matériau piézoélectrique dont la déformation est insensible à la polarisation du courant électrique le parcourant permet tout de même de déformer la poutre 305 dans un sens ou dans l'autre.

Sur la figure 5, le matériau piézoélectrique 302 est donc situé sous la poutre 305, c'est-à-dire qu'il est situé entre la poutre 305 et la membrane 12. Lorsqu'une tension électrique est appliquée au matériau piézoélectrique 302, il se rétracte et entraîne avec lui la poutre 305. La poutre 305 se courbe vers le bas, entraînant avec elle la zone de la membrane 12 liée à la poutre 305. Par conservation de volume, la zone libre 121 de la membrane se déplace quant à elle vers le haut. Ce cas de figure correspond à celui illustré en figure 3B. Les extrémités de la poutre 305 restent fixes. Ses extrémités peuvent plus particulièrement être mises en prise entre le capot 18 d'une part et une paroi fixe 306 de la première cavité 13 d'autre part, voire également avec une entretoise 19 optionnelle. L'entretoise 19 peut prendre la forme d'un pilier ou d'un muret. Elle permet de soutenir la membrane 12. Le milieu déformable 14 entoure cette entretoise 19. Cette entretoise 19 fait office de pilier à l'intérieur de la cavité 13. Le cas échéant, l'entretoise 19 permet, par exemple conjointement avec la portion du capot 18 qui la surplombe, de rigidifier un contour du transducteur électromécanique 11, de sorte que sa déformation soit le plus intégralement possible traduite en une déformation de la membrane 12. Plusieurs entretoises 19 peuvent être prévues.

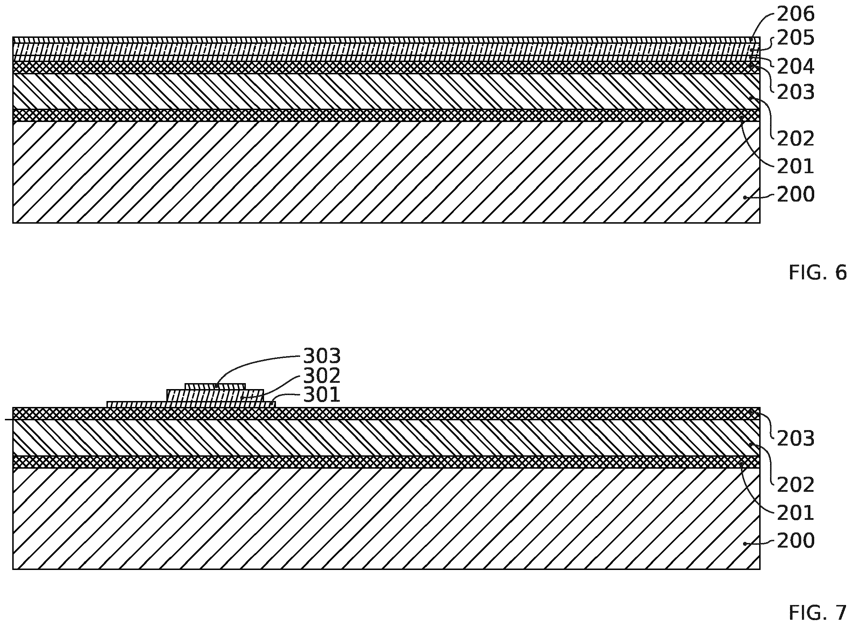

La figure 5 illustre plus particulièrement un mode de réalisation de l'invention qui a été obtenu par des étapes de dépôt et de gravure pouvant être qualifiées comme ordinaires dans le domaine de la microélectronique. Plus particulièrement, le microsystème électromécanique 1 selon le mode de réalisation illustré sur la figure 5 a été obtenu par la succession d'étapes illustrées par les figures 6 à 12.

Ce procédé de fabrication comprend :
- une étape de formation, sur un substrat 200, d'une portion au moins dudit au moins un transducteur électromécanique 11, puis
- une étape de dépôt de la membrane déformable 12, puis
- une étape de formation d'au moins une première cavité 13 ouverte sur la membrane déformable 12, puis
- une étape de remplissage avec le milieu déformable 14 et de fermeture de la première cavité 13, et
- une étape de gravure du substrat 200 pour former une deuxième cavité 20 ouverte et une face avant FAV du microsystème électromécanique 1 tel qu'illustré sur la figure 5 comprenant la deuxième cavité 20.

### Exemples d'étapes de procédés de fabrication

Nous décrivons ci-dessous le procédé de fabrication susmentionné

La première étape de ce procédé est illustrée sur la figure 6. Elle consiste à fournir un substrat 200 sur lequel un empilement de couches s'étend qui peut comprendre successivement, depuis une face du substrat 200 :
- une première couche isolante 201, par exemple à base d'oxyde de silicium, pouvant être déposée par dépôt chimique en phase vapeur assisté par plasma (ou PECVD, pour Plasma-Enhanced Chemical Vapor Déposition en anglais),
- une couche 202 destinée à constituer la poutre 305 du transducteur électromécanique 11, cette couche 202 étant par exemple à base de silicium amorphe et pouvant être déposée par dépôt chimique en phase vapeur (ou CVD pour l'anglais chemical vapor déposition) à pression sous-atmosphérique (ou LPCVD) ou par utilisation d'une structure de type SOI (pour Silicon On Insulator ou, en français, silicium sur isolant),
- une deuxième couche isolante 203, par exemple à base d'oxyde de silicium et pouvant être déposée par PECVD,
- une couche 204 destinée à constituer une électrode dite inférieure, par exemple à base de platine et pouvant être déposée par dépôt physique en phase vapeur (ou PVD pour l'anglais physical vapor déposition),
- une couche 205 en un matériau piézoélectrique, par exemple à base de PZT, et pouvant être déposée par un procédé sol gel, et
- une couche 206 destinée à constituer une électrode dite supérieure, par exemple à base de platine et pouvant être déposée par PVD.

La deuxième étape du procédé de fabrication du microsystème électromécanique 1 tel qu'illustré sur la figure 5 est illustrée sur la figure 7. Elle comprend :
- une gravure de la couche 206 de sorte à former l'électrode supérieure 301 du transducteur électromécanique 11,
- une gravure de la couche 205 de sorte à former les éléments piézoélectriques 302 du transducteur électromécanique 11, et
- une gravure de la couche 204 de sorte à former l'électrode inférieure 303 du transducteur électromécanique 11.

Notons que chacune de ces gravures peut être réalisée par lithographie, et préférentiellement par gravure au plasma, ou par voie chimique humide.

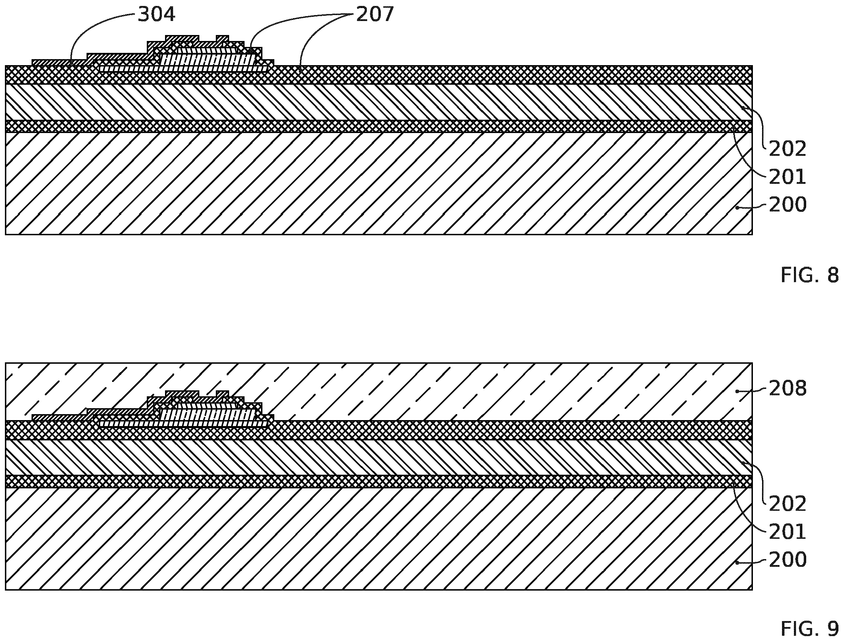

La troisième étape du procédé de fabrication du microsystème électromécanique 1 tel qu'illustré sur la figure 5 est illustrée sur la figure 8. Elle comprend :
- le dépôt d'une couche de passivation 207, par exemple à base d'oxyde de silicium et/ou de nitrure de silicium, pouvant être déposée par PECVD,
- l'ouverture, à travers la couche de passivation 207, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304 par électrode, la couche étant par exemple à base d'or et pouvant être déposée par PVD, et
- une gravure de la couche précédemment déposée de sorte à former une ligne électrique 304 par électrode, cette gravure étant réalisée par exemple par lithographie, et préférentiellement par gravure au plasma, ou par voie chimique humide.

La quatrième étape du procédé de fabrication du microsystème électromécanique 1 tel qu'illustré sur la figure 5 est illustrée sur la figure 9. Elle comprend le dépôt d'une couche 208 à base d'un polymère et destinée à constituer la membrane déformable 12. Cette couche 208 est par exemple déposée par enduction centrifuge (ou *spin coating* en anglais). Le polymère à base duquel la couche 208 est constituée est par exemple à base de PDMS.

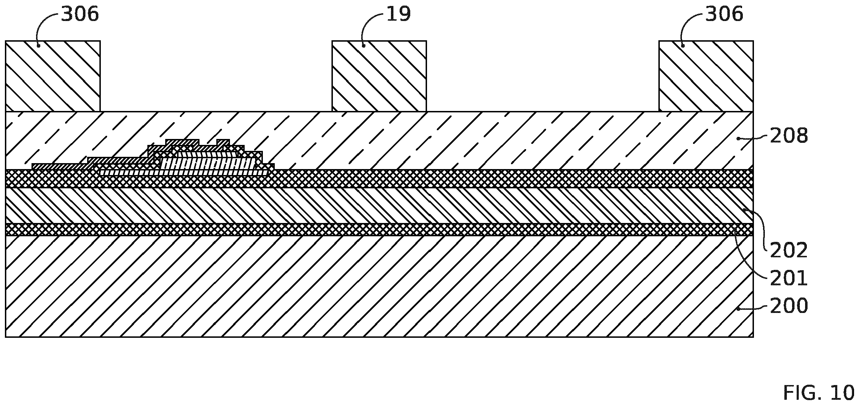

La cinquième étape du procédé de fabrication du microsystème électromécanique 1 tel qu'illustré sur la figure 5 est illustrée sur la figure 10. Elle comprend la formation d'au moins un espaceur 306 destiné à constituer au moins une partie de ladite au moins une paroi 133 latérale de la cavité 13. Elle peut comprendre en outre la formation d'une entretoise 19. Cette entretoise 19 permet de soutenir la membrane 12 et de fixer le transducteur électromécanique 11 d'un de ses côtés. Le milieu déformable 14 entoure cette entretoise 19. Cette entretoise 19 fait office de pilier à l'intérieur de la cavité 13. La formation du ou des espaceurs 306 et de l'éventuelle entretoise 19 peut comprendre le laminage d'un matériau photosensible à base duquel le ou les espaceurs sont constitués, l'insolation, puis le développement du matériau photosensible. Ledit matériau photosensible peut être à base d'un polymère, et notamment à base de Siloxane. Le laminage du matériau photosensible peut comprendre le laminage d'un film sec dudit matériau.

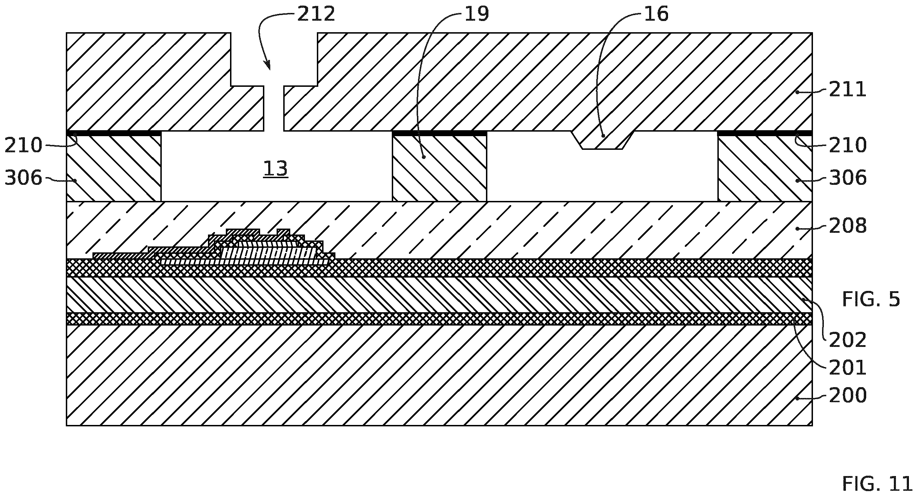

La sixième étape du procédé de fabrication du microsystème électromécanique 1 tel qu'illustré sur la figure 5 est illustrée sur la figure 11. Selon un mode de réalisation optionnelle, cette étape comprend le dépôt de colle 210 au sommet de chaque espaceur 306, et le cas échéant de l'éventuelle entretoise19, ce dépôt pouvant être réalisé par sérigraphie ou par dispense. Elle comprend la fixation, par exemple le collage, sur le sommet du ou des espaceurs (éventuellement par l'intermédiaire de la colle 210), d'un second substrat 211 pouvant être structuré de sorte à comprendre au moins l'un parmi un évent traversant 212 et une butée basse 16 telle que décrite ci-dessus. Dans un mode de réalisation alternatif, selon la nature de l'espaceur, celui-ci peut jouer le rôle de colle. À l'issue de cette sixième étape, la première cavité 13 est formée qui est ouverte par au moins un évent traversant 212.

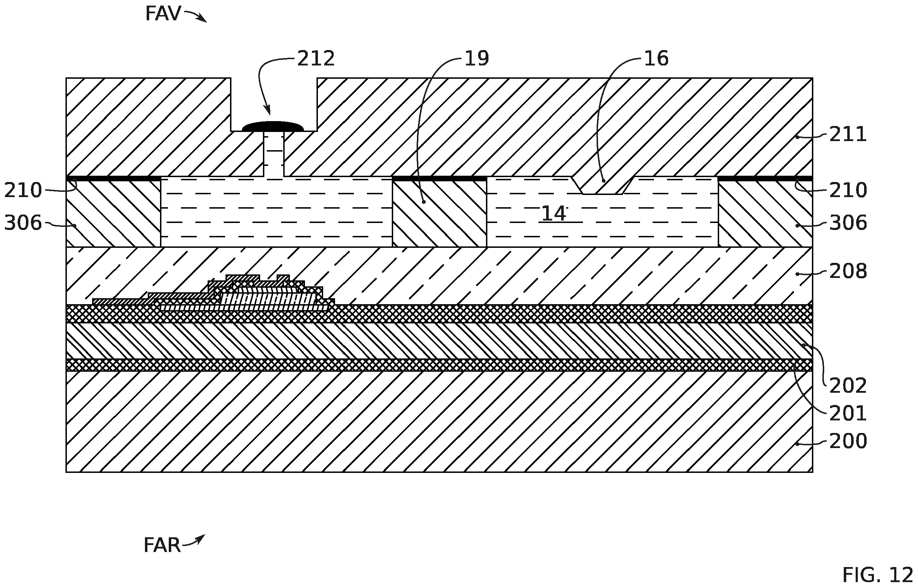

La septième étape du procédé de fabrication du microsystème électromécanique 1 tel qu'illustré sur la figure 5 est illustrée sur la figure 12. Elle comprend le remplissage, de préférence sous vide, de la première cavité 13 avec le milieu déformable 14 tel que décrit ci-dessus, par exemple par dispense à travers l'évent traversant 212. Elle comprend également la fermeture étanche de l'au moins un évent traversant 212, par exemple par dispense d'un matériau de scellement 213 à l'embouchure de chaque évent traversant 212, le matériau de scellement 213 étant par exemple à base d'une colle époxy.

Une étape additionnelle permet d'obtenir le microsystème électromécanique 1 tel qu'illustré sur la figure 5. Elle comprend la gravure du substrat 200. Cette gravure peut être réalisée par lithographie, et préférentiellement par gravure au plasma, ou par voie chimique humide. Elle comprend ensuite la gravure de la couche 202 et des couches isolantes 201, 203 de sorte à former au moins une poutre 305 du transducteur électromécanique 11, à exposer une partie de la membrane déformable 12 et à constituer tout ou partie de la paroi latérale 22 de la deuxième cavité 20.

Notons que, suite aux étapes décrites ci-dessus de fabrication du microsystème électromécanique 1 tel qu'illustré sur la figure 5, la paroi latérale 22 de la deuxième cavité 20 prend la forme d'un empilement, par exemple annulaire, s'étendant, directement ou indirectement, depuis la membrane déformable 12 à l'opposé de la première cavité 13 en présentant successivement le matériau de la couche isolante 201, le matériau constituant la poutre 305, le matériau de la couche isolante 203 et le matériau constituant le substrat 200.

### Autres modes de réalisation

En reprenant les principes, les caractéristiques et les effets techniques mentionnés en référence aux modes de réalisation décrits ci-dessus, de nombreuses variantes peuvent être envisagées. Quelques-unes de ses variantes sont brièvement exposées ci-dessous. Toutes les caractéristiques et tous les effets techniques mentionnés dans les exemples qui vont suivre et dans les exemples décrits ci-dessus sont combinables.

### Forme de la zone libre 121 et du transducteur électromécanique 11

Les formes de la zone libre 121 de la membrane 12 peuvent être adaptées avec une forte liberté en fonction des objectifs que l'on cherche à atteindre. Ces objectifs concernent par exemple la forme que l'on souhaite donner à l'ouverture 23 de la deuxième cavité 20.

La zone libre 121 peut présenter une forme de disque ou une forme d'oblong ou d'ellipsoïde.

En alternative, la zone libre 121 peut présenter une forme polygonale, par exemple la forme d'un carré ou former un contour ouvert, par exemple en forme de « U ».

De même que pour la forme de la zone libre 121, la forme du transducteur électromécanique 11 peut être adaptée comme on le souhaite.

### Nombre et disposition relative des transducteurs électromécaniques

Sur les modes de réalisation illustrée sur les figures 1A et 2A, un seul transducteur électromécanique 11 et deux transducteurs électromécaniques 11a et 11b sont représentés, respectivement.

Pour chacun de ces modes de réalisation, on peut néanmoins prévoir plusieurs transducteurs électromécaniques pour un même microsystème électromécanique 1.

Naturellement, le nombre de transducteurs électromécaniques 11 peut être supérieur à deux.

Les transducteurs électromécaniques peuvent être sollicités simultanément ou successivement. L'amplitude de déformation de la membrane induite par chaque transducteur électromécanique peut être identique ou différente.

La présence de plusieurs transducteurs électromécaniques dans un même microsystème électromécanique 1 permet des modes de fonctionnement variés.

Selon un mode de réalisation, les transducteurs électromécaniques peuvent être configurés pour que, sous sollicitation, leurs parties mobiles induisent des déformations de la zone libre 121 dans un même sens. La déformation totale de la membrane résulte alors du cumul du déplacement des parties mobiles de ces transducteurs électromécaniques. Cela permet d'augmenter encore l'amplitude de variation du volume de la deuxième cavité 20.

Par ailleurs, lorsque les transducteurs électromécaniques peuvent être activés indépendamment les uns des autres ou successivement, le microsystème électromécanique 1 présente alors un fonctionnement pas à pas. Cela permet de contrôler avec une précision encore plus grande la variation du volume de la deuxième cavité 20.

Selon un autre mode de réalisation, éventuellement combinable avec le mode de réalisation pas à pas, au moins certains des transducteurs électromécaniques peuvent être configurés pour que, sous sollicitation, ils induisent une déformation de la membrane dans deux sens opposés, comme illustré sur la figure 2A. Ces deux transducteurs électromécaniques sont donc antagonistes. Ainsi, au moins l'un de ces transducteurs électromécaniques permet de déformer la membrane selon un premier sens et au moins un autre de ces transducteurs électromécaniques permet de déformer la membrane selon un deuxième sens opposé au premier sens. Cela permet d'augmenter encore l'amplitude de variation du volume de la deuxième cavité.

L'invention n'est pas limitée aux modes de réalisation précédemment décrits et s'étend à tous les modes de réalisation couverts par les revendications.

De nombreuses applications du microsystème électromécanique 1 sont envisageables. Par exemple, le microsystème électromécanique 1 peut être agencé dans un microbaromètre, dans un système d'auto-assemblage de composants microélectroniques ou dans un système à membrane vibratoire, et éventuellement acoustique.

## Revendications

1. Microsystème électromécanique (1) comprenant :
• au moins un transducteur électromécanique (11) comprenant une partie mobile (111) entre une position d'équilibre, hors sollicitation, et une position hors équilibre, sous sollicitation,
• au moins une membrane déformable (12),
• une première cavité (13) déformable, délimitée par des parois (131, 132, 133), au moins une partie de la membrane déformable (12) formant au moins une partie d'une première paroi (131) prises parmi lesdites parois (131, 132, 133) de la première cavité (13), la première cavité (13) étant configurée pour contenir hermétiquement un milieu déformable (14) propre à conserver un volume sensiblement constant sous l'action d'un changement de pression externe exercée sur le milieu déformable (14) à travers l'une des parois (131, 132, 133) de la première cavité (13),
• au moins une deuxième cavité (20) déformable, présentant un volume variable délimité par des parois (21, 22) et une ouverture (23),
dans lequel la partie mobile (111) du transducteur électromécanique (11) est configurée de sorte que son mouvement soit fonction dudit changement de pression externe, ou inversement que son mouvement induise un changement de pression externe dans la première cavité (13),
dans lequel ladite au moins une partie de la membrane déformable (12) présente au moins une zone libre (121) libre de se déformer, de préférence de façon élastique, en fonction dudit changement de pression externe, et
dans lequel au moins une partie d'une première paroi (21) prise parmi lesdites parois (21, 22) de la deuxième cavité (20) est formée d'au moins une partie de ladite au moins une zone libre (121) de la membrane (12), de sorte qu'un changement de pression externe dans la première cavité (13) induise une variation du volume de la deuxième cavité (20), ou inversement qu'une variation du volume de la deuxième cavité (20) induise un changement de pression externe dans la première cavité (13),
dans lequel l'ouverture (23) de la deuxième cavité (20) est destinée à être alternativement obstruée et dégagée par un objet (3), et
le microsystème électromécanique (1) comprenant en outre une couche souple (24) configurée pour être intercalée entre au moins l'une des parois (21, 22) de la deuxième cavité (20) et une partie de l'objet (3) destiné à obstruer la deuxième cavité.

2. Microsystème électromécanique (1) selon la revendication précédente, dans lequel, la membrane (12) présentant une face interne (12i) configurée pour être au contact du milieu déformable (14) et une face externe (12e), la face interne (12i) de la membrane (12) forme au moins une partie de la première paroi (131) de la première cavité (13) et la face externe (12e) de la membrane forme au moins une partie de la première paroi (21) de la deuxième cavité (20).

3. Microsystème électromécanique (1) selon l'une quelconque des revendications précédentes, dans lequel une zone sur laquelle s'étend la première paroi (21) de la deuxième cavité (20) est exempte de toute partie mobile (111) d'un transducteur électromécanique (11).

4. Microsystème électromécanique (1) selon l'une quelconque des revendications précédentes, dans lequel la deuxième cavité (20) comprend, parmi ces parois (21, 22), une paroi latérale (22) s'étendant depuis un pourtour de sa première paroi (21) à l'opposé de la première cavité (12).

5. Microsystème électromécanique (1) selon la revendication précédente, dans lequel la paroi latérale (22) définie une extrémité distale (221) et l'ouverture (23) est formée au moins en partie par l'extrémité distale (221) de la paroi latérale (22).

6. Microsystème électromécanique (1) selon l'une quelconque des revendications précédentes, dans lequel la première paroi (21) de la deuxième cavité (20) est formée d'une partie seulement de ladite au moins une zone libre (121) de la membrane (12), la deuxième cavité (20) comprenant une paroi latérale (22) s'étendant depuis ladite au moins une zone libre (121) de la membrane (12).

7. Microsystème électromécanique (1) selon l'une quelconque des revendications précédentes, comprenant une pluralité de deuxièmes cavités (20) séparées les unes des autres d'une distance non nulle.

8. Microsystème électromécanique (1) selon l'une quelconque des revendications précédentes, dans lequel la partie mobile (111) d'au moins un transducteur électromécanique (11) est configurée de sorte que sa sollicitation induise son mouvement vers le centre de la première cavité, une déformation de la zone libre (121) de la membrane déformable (12) à l'opposé du centre de la première cavité (13) et par voie une diminution du volume de la deuxième cavité (20) et de sorte qu'une absence subséquente de sollicitation induise son mouvement à l'opposé du centre de la cavité, une déformation de la zone libre (121) de la membrane déformable (12) vers le centre de la première cavité (13) et par voie une augmentation du volume de la deuxième cavité (20).

9. Microsystème électromécanique (1) selon l'une quelconque des revendications précédentes, dans lequel ledit au moins un transducteur électromécanique (11) est configuré de sorte à induire sélectivement une diminution et une augmentation du volume de la deuxième cavité (20).

10. Microsystème électromécanique (1) selon l'une quelconque des revendications précédentes, dans lequel ledit au moins un transducteur électromécanique (11) est configuré pour exercer sur le milieu déformable (14), lorsqu'il est sollicité, un changement de pression externe déterminé et dans lequel la forme et/ou les dimensions de ladite au moins une zone libre (121) de la membrane déformable (12) sont configurées pour induire, en fonction dudit changement de pression externe déterminé, une variation de volume de la deuxième cavité (20) propre à générer une force d'aspiration d'un objet (3) obstruant l'ouverture (23), ladite force d'aspiration étant supérieure au poids de l'objet (3).

11. Microsystème électromécanique (1) selon l'une quelconque des revendications précédentes, dans lequel la membrane déformable (12) est configurée de sorte que sa zone libre (121) est capable de se déformer avec une amplitude d'au moins 50 µm, voire d'environ 100 µm.

12. Ensemble comprenant un microsystème électromécanique (1) selon l'une quelconque des revendications précédentes et au moins un objet destiné à obstruer l'ouverture (23).

13. Ensemble selon la revendication précédente, dans lequel la paroi latérale (22) définie une extrémité distale (221) et l'ouverture (23) est formée au moins en partie par l'extrémité distale (221) de la paroi latérale (22), et dans lequel l'extrémité distale (221) de la paroi latérale (22) est conformée de sorte à ce que, lorsque l'objet (3) obstrue l'ouverture (23), une déformation de la membrane déformable (12) tendant à augmenter le volume de la deuxième cavité (20) créer une baisse de pression dans la deuxième cavité (20).

14. Procédé de fabrication d'un microsystème électromécanique (1) selon l'une quelconque des revendications 1 à 11, comprenant :
• une étape de formation, sur un substrat (200), d'une portion au moins dudit au moins un transducteur électromécanique (11), puis
• une étape de dépôt de la membrane déformable (12), puis
• une étape de formation d'au moins une première cavité (13) ouverte sur la membrane déformable (12), puis
• une étape de remplissage avec le milieu déformable (14) et de fermeture de la première cavité (13), et
• une étape de gravure du substrat (200) pour former une deuxième cavité (20) ouverte et une face avant (FAV) du microsystème électromécanique (1) comprenant la deuxième cavité (20).
